(19) Europäisches Patentamt / European Patent Office / Office européen des brevets

(11) **EP 4 509 306 A1**

(12) **EUROPEAN PATENT APPLICATION**
published in accordance with Art. 153(4) EPC

(43) Date of publication:
**19.02.2025 Bulletin 2025/08**

(21) Application number: **23900696.8**

(22) Date of filing: **06.12.2023**

(51) International Patent Classification (IPC):
**B32B 15/08** (2006.01)    **B32B 38/08** (2006.01)
**C08J 5/24** (2006.01)    **H05K 1/03** (2006.01)
**H05K 3/46** (2006.01)

(52) Cooperative Patent Classification (CPC):
**B32B 15/08; B32B 38/08; C08J 5/24; H05K 1/03; H05K 3/46**

(86) International application number:
**PCT/JP2023/043679**

(87) International publication number:
**WO 2024/122584 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.12.2022 JP 2022195972**

(71) Applicant: Resonac Corporation
**Tokyo 105-7325 (JP)**

(72) Inventors:
• **KITAJIMA Takayo**
  **Tokyo 105-7325 (JP)**
• **TONOUCHI Shunsuke**
  **Tokyo 105-7325 (JP)**
• **MAGOTA Seiya**
  **Tokyo 105-7325 (JP)**
• **NAKANISHI Kota**
  **Tokyo 105-7325 (JP)**

(74) Representative: **Hoffmann Eitle**
**Patent- und Rechtsanwälte PartmbB**
**Arabellastraße 30**
**81925 München (DE)**

(54) **METAL-CLAD LAMINATE, PRINTED WIRING BOARD, SEMICONDUCTOR PACKAGE, AND METHOD FOR MANUFACTURING SAME**

(57)    Provided are a method for producing a metal-clad laminate, including: laminating a prepreg and a metal foil by heating and pressurizing, in which the prepreg contains a thermosetting resin composition and a fiber base material having a thickness of 40 $\mu$m or more, the prepreg has a first resin layer which is provided on one surface of the fiber base material and contains the thermosetting resin composition; and a second resin layer which is provided on the other surface of the fiber base material and contains the thermosetting resin composition, in which when a thickness of the first resin layer is $d_1$ and a thickness of the second resin layer is $d_2$, a ratio R of a thickness difference represented by formula (1) is -9.0% to +9.0%, and surface waviness (Wa) of each of both surfaces of the prepreg is 6 $\mu$m or less, and a printed wiring board and a semiconductor package using the metal-clad laminate.

[Fig. 1]

**Description**

Technical Field

The present embodiment relates to a metal-clad laminate, a printed wiring board, a semiconductor package, and methods for producing these.

Background Art

In recent years, electronic devices have been reduced in size and weight, and enhanced in functionality, and semiconductor devices mounted in electronic devices have been highly integrated. Accordingly, higher quality than before has been required for metal-clad laminates, semiconductor packages, and the like used for printed wiring boards.

For example, a metal-clad laminate is required to have higher thickness accuracy than ever before from the viewpoint of increasing the productivity of a printed wiring board to be obtained. In addition, the metal-clad laminate may be subjected to various treatments such as a heat treatment and a chemical treatment, and it is required that the amount of dimensional change caused by these treatments does not vary among products.

Furthermore, for the semiconductor package, it is required to reduce the variation in the amount of warpage between products as compared with the conventional package.

PTL 1 discloses a method for producing a prepreg by a method in which a base material is immersed in a resin liquid and then dried, the method being characterized in that convex resin protrusions generated on the surface of the prepreg are crushed by pressurizing the prepreg with a roll during the drying process or after the drying is completed to improve the smoothness of the surface.

Citation List

Patent Literature

PTL 1: JP 01-272416 A

Summary of Invention

Technical Problem

In the technique of PTL 1, the surface of the prepreg is mechanically pressurized to improve the smoothness.

However, as described above, the progress of high integration of semiconductor devices is remarkable, and it is difficult to achieve thickness accuracy of a metal-clad laminate at a level required in recent years by the technique of PTL 1. In addition, the technique of PTL 1 does not solve the problems of uniformizing the amount of dimensional change of the metal-clad laminate and reducing the variation in the amount of warpage of the semiconductor package.

In particular, the present inventors have made studies and found that when the thickness of the fiber base material used in the prepreg is increased to a level of 40 $\mu$m or more, it becomes more difficult to improve the thickness accuracy and uniformity of the amount of dimensional change of the metal-clad laminate and reduce the variation in the amount of warpage of the semiconductor package.

In view of such a current situation, an object of the present embodiment is to provide a method for producing a metal-clad laminate having excellent thickness accuracy and uniformity of the amount of dimensional change even when a fiber base material having a thickness of 40 $\mu$m or more is used, a method for producing a printed wiring board and a semiconductor package using the metal-clad laminate, as well as a metal-clad laminate capable of reducing variation in the amount of warpage of a semiconductor package even when a fiber base material having a thickness of 40 $\mu$m or more is used, and a printed wiring board and a semiconductor package having the metal-clad laminate.

Solution to Problem

As a result of studies to solve the above problems, the present inventors have found that the problems can be solved by the present embodiment described below.

That is, the present embodiment relates to the following [1] to [11].

[1] A method for producing a metal-clad laminate, including: laminating a prepreg and a metal foil by heating and pressurizing,

in which the prepreg contains a thermosetting resin composition and a fiber base material having a thickness of 40 μm or more,

the prepreg has a first resin layer which is provided on one surface of the fiber base material and contains the thermosetting resin composition; and a second resin layer which is provided on the other surface of the fiber base material and contains the thermosetting resin composition,

in which when a thickness of the first resin layer is $d_1$ and a thickness of the second resin layer is $d_2$, a thickness difference ratio R represented by the following formula (1) is -9.0% to +9.0%,

$$R = (d_1 - d_2) \times 100/(d_1 + d_2) \qquad (1),$$

and

surface waviness (Wa) of each of both surfaces of the prepreg is 6 μm or less.

[2] The method for producing a metal-clad laminate according to [1], in which the prepreg has an impregnated region and an unimpregnated region of the thermosetting resin composition in the fiber base material.

[3] The method for producing a metal-clad laminate according to [1] or [2], in which the thickness $d_1$ of the first resin layer and the thickness $d_2$ of the second resin layer are each 2 to 20 μm.

[4] The method for producing a metal-clad laminate according to any one of [1] to [3], in which the thickness of the fiber base material is 40 to 120 μm.

[5] The method for producing a metal-clad laminate according to any one of [1] to [4], in which the fiber base material is a glass cloth.

[6] A method for producing a printed wiring board, including: producing a metal-clad laminate by the method for producing a metal-clad laminate according to any one of [1] to [5]; and forming a wiring pattern on the metal-clad laminate.

[7] A method for producing a semiconductor package, including: producing a printed wiring board by the method for producing a printed wiring board according to [6]; and mounting a semiconductor element on the printed wiring board.

[8] A metal-clad laminate containing a cured product of a thermosetting resin composition, one or more layers of a fiber base material, and a metal foil, in which the fiber base material has a thickness of 40 μm or more, and a value obtained according to the following method is 0.5% or less:

(method)

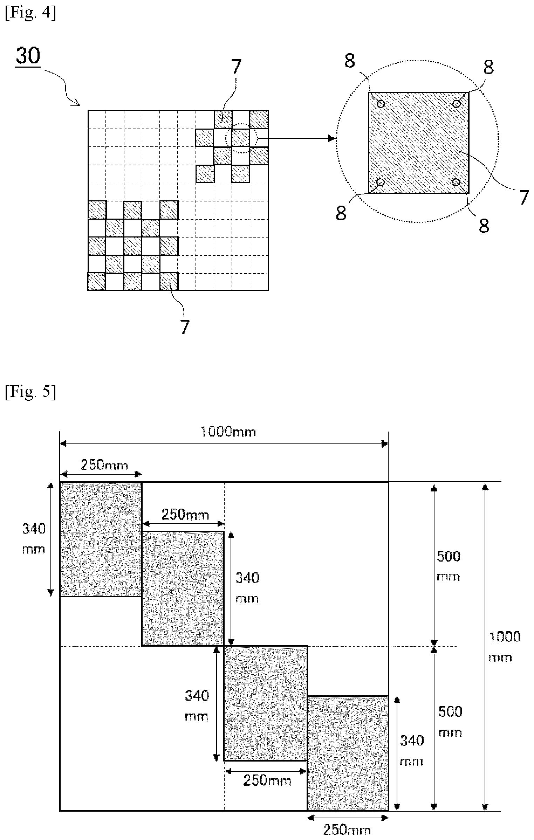

a region of 500 mm × 500 mm in the plane of the metal-clad laminate is sectioned in a grid shape at intervals of 50 mm in the vertical direction and the horizontal direction, respectively, and 21 measurement unit areas 7 each having a square shape of 50 mm in length × 50 mm in width when seen from a plan view are set at positions shown in a plan view of a metal-clad laminate 30 of Fig. 4;

thicknesses are measured at positions of four thickness measurement points 8 shown in Fig. 4, which are points 10 mm apart from the vertical side and the horizontal side of the measurement unit area 7 toward the inside of the measurement unit area 7, respectively, and a difference between a maximum value and a minimum value of the thicknesses at the four points is defined as a thickness difference $V_1$ in the measurement unit area 7, and an average value of the thicknesses at the four points is defined as $T_1$;

$V_1$ and $T_1$ are obtained for each of the 21 measurement unit areas 7, and a value is calculated from an average value $V_{ave}$ of $V_1$ and an average value $T_{ave}$ of $T_1$ by the following equation:

$$V_{ave} \times 100/T_{ave}.$$

[9] The metal-clad laminate according to [8], in which the metal-clad laminate has the metal foil on both surfaces thereof, and includes:

a first resin cured product layer which is provided on a surface of the fiber base material, is in contact with the metal foil on one surface of the metal-clad laminate, and contains a cured product of a thermosetting resin composition; and

a second resin cured product layer which is provided on a surface of the fiber base material, is in contact with the metal foil on the other surface of the metal-clad laminate, and contains a cured product of a thermosetting resin composition;

in which, when a thickness of the first resin cured product layer is $d'_1$ and a thickness of the second resin cured product layer is $d'_2$, a thickness difference ratio R' represented by the following formula (1') is -9.0% to +9.0%,

$$R' = (d'_1 - d'_2) \times 100/(d'_1 + d'_2) \qquad (1').$$

[10] A printed wiring board containing the metal-clad laminate according to [8] or [9].
[11] A semiconductor package including the printed wiring board according to [10], and a semiconductor element.

Advantageous Effects of Invention

According to the present embodiment, it is possible to provide a method for producing a metal-clad laminate having excellent thickness accuracy and uniformity of the amount of dimensional change even when a fiber base material having a thickness of 40 $\mu$m or more is used, a method for producing a printed wiring board and a semiconductor package using the metal-clad laminate, as well as a metal-clad laminate capable of reducing variation in the amount of warpage of a semiconductor package even when a fiber base material having a thickness of 40 $\mu$m or more is used, and a printed wiring board and a semiconductor package having the metal-clad laminate.

Brief Description of Drawings

Fig. 1 is a schematic cross-sectional view showing one aspect of a prepreg used in the production method of the present embodiment.
Fig. 2 is a schematic cross-sectional view showing one aspect of a prepreg having an intermittent unimpregnated region in the plane direction.
Fig. 3 is an image used for calculating the abundance ratio of the impregnated region in the prepreg prepared in Example 1.
Fig. 4 is a schematic plan view for illustrating a method for measuring a thickness of a metal-clad laminate.
Fig. 5 is a schematic plan view for illustrating a method for measuring a variation in an amount of dimensional change of a metal-clad laminate.

Description of Embodiments

In the description herein, a numerical range indicated by using "to" indicates a range including numerical values described before and after "to" as a minimum value and a maximum value, respectively.
For example, the expression of a numerical range "X to Y" (X and Y are real numbers) means a numerical range that is X or more and Y or less. Further, the expression of "X or more" in the description herein means X and a numerical value exceeding X. Furthermore, the expression of "Y or less" in the description herein means Y and a numerical value less than Y.
The lower limit value and the upper limit value of a numerical range described in the description herein can be arbitrarily combined with the lower limit value or the upper limit value of another numerical range, respectively.
In a numerical range described in the description herein, the lower limit value or the upper limit value of the numerical range may be replaced with a value shown in Examples.
Each component and material exemplified in the description herein may be used alone or may be used in combination of two or more kinds thereof, unless particularly otherwise specified.
In the description herein, when a plurality of substances corresponding to each component are present in a resin composition, the content of each component in the resin composition means the total amount of the plurality of substances present in the resin composition, unless particularly otherwise specified.
In the description herein, a "solid content" means a component other than a solvent, and a component in a liquid state at room temperature is also regarded as a solid content. In the description herein, the room temperature indicates 25°C.
The mechanism of action described in the description herein is a guess, and does not limit the mechanism of achieving the effect of the present embodiment.
The expression "containing xx" described in the description herein includes not only a case where "xx" is simply contained, but also a case where "xx" is contained in a reacted state in a case where something described in "xx" can react.
An aspect in which the matters described in the description herein are arbitrarily combined is also included in the present embodiment.

[Method for Producing Metal-Clad Laminate]

The method for producing a metal-clad laminate of the present embodiment is a method for producing a metal-clad laminate, including: laminating a prepreg and a metal foil by heating and pressurizing,

in which the prepreg contains a thermosetting resin composition and a fiber base material having a thickness of 40 $\mu$m or more,
the prepreg has a first resin layer which is provided on one surface of the fiber base material and contains the thermosetting resin composition; and a second resin layer which is provided on the other surface of the fiber base material and contains the thermosetting resin composition,
in which when a thickness of the first resin layer is $d_1$ and a thickness of the second resin layer is $d_2$, a thickness difference ratio R represented by the following formula (1) is -9.0% to +9.0%,

$$R = (d_1 - d_2) \times 100/(d_1 + d_2) \qquad (1),$$

and
surface waviness (Wa) of both surfaces of the prepreg is each 6 $\mu$m or less.

In the following description, a prepreg having the above-described configuration, that is, a prepreg containing a thermosetting resin composition and a fiber base material having a thickness of 40 $\mu$m or more, having the first resin layer and the second resin layer, in which the thickness difference ratio R is -9.0% to +9.0%, and the surface waviness (Wa) of each of both surfaces is 6 $\mu$m or less, may be referred to as a "prepreg (P)".

The reason why the metal-clad laminate produced by the production method of the present embodiment is excellent in the thickness accuracy and the uniformity of the amount of dimensional change is not clear, but is presumed as follows.

The prepreg (P) used in the present embodiment has a configuration in which the thickness difference ratio R represented by the above formula (1) is -9.0% to +9.0% and the surface waviness (Wa) of both surfaces is 6 $\mu$m or less. That is, in the prepreg (P) used in the present embodiment, the amount of the thermosetting resin composition adhering to the front and back surfaces of the fiber base material is uniform, and the surface thereof is smooth. As a result, the residual thickness variation of the prepreg itself and the homogeneity of the flow behavior of the thermosetting resin composition on the front and back surfaces of the prepreg at the time of pressurization were improved, which is presumed to be one of the reasons why the thickness accuracy and the uniformity of the amount of dimensional change of the metal-clad laminate could be improved.

Hereinafter, each member used in the method for producing the metal-clad laminate of the present embodiment will be described first, and then the lamination conditions of each member and the like will be described.

<Prepreg (P)>

The prepreg (P) used in the present embodiment contains a thermosetting resin composition and a fiber base material having a thickness of 40 $\mu$m or more, and has a first resin layer which is provided on one surface of the fiber base material and contains the thermosetting resin composition, and a second resin layer which is provided on the other surface of the fiber base material and contains the thermosetting resin composition.

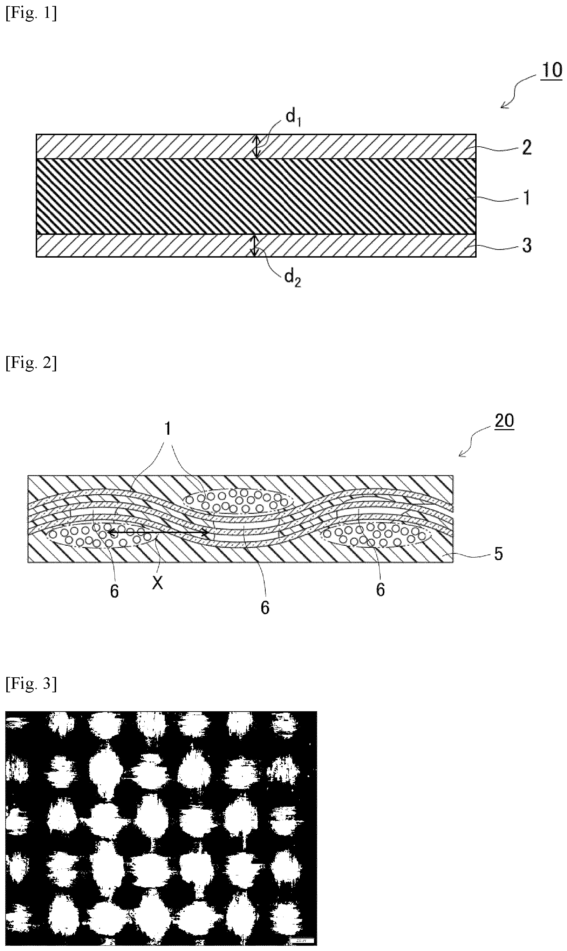

Fig. 1 shows a schematic cross-sectional view showing an example of the prepreg (P) used in the present embodiment.

A prepreg 10 shown in Fig. 1 has a fiber base material 1, a first resin layer 2 having a thickness $d_1$ provided on one surface of the fiber base material 1, and a second resin layer 3 having a thickness $d_2$ provided on the other surface of the fiber base material 1. The fiber base material 1 preferably has an impregnated region of the thermosetting resin composition, and more preferably has an impregnated region and an unimpregnated region of the thermosetting resin composition.

In the prepreg 10, the surface of the first resin layer 2 on the side opposite to the fiber base material 1 constitutes one surface of the prepreg 10, and the surface of the second resin layer 3 on the side opposite to the fiber base material 1 constitutes the other surface of the prepreg 10.

The thermosetting resin composition contained in the first resin layer and the thermosetting resin composition contained in the second resin layer may be the same as or different from each other, but are preferably the same as each other.

In addition, in a case where the thermosetting resin composition contained in the first resin layer and the thermosetting resin composition contained in the second resin layer are the same as each other, these thermosetting resin compositions and the thermosetting resin composition contained in the fiber base material may be the same as or different from each other, but are preferably the same as each other.

It is preferable that the first resin layer and the second resin layer do not contain a fiber base material.

(Thickness Difference Ratio R)

In the prepreg (P) used in the present embodiment, when the thickness of the first resin layer is $d_1$ and the thickness of the second resin layer is $d_2$, the thickness difference ratio R represented by the following formula (1) is -9.0% to +9.0%.

$$R = (d_1 - d_2) \times 100/(d_1 + d_2) \quad (1)$$

The thickness difference ratio R represented by the above formula (1) is preferably -8.0% to +8.0%, more preferably -7.0% to +7.0%, further preferably -6.0% to +6.0%, particularly preferably -5.0% to +5.0%, from the viewpoint of further improving the thickness accuracy and the uniformity of the amount of dimensional change of the metal-clad laminate.

The thickness $d_1$ of the first resin layer and the thickness $d_2$ of the second resin layer used for calculating the thickness difference ratio R can be measured by the following method. More detailed conditions can be the conditions described in Examples.

[Method for Measuring Thickness $d_1$ of First Resin Layer and Thickness $d_2$ of Second Resin Layer]

A cross section of the prepreg subjected to the heat treatment as necessary is formed, the cross section is observed with a metallurgical microscope, and a cross-sectional image is acquired. In the obtained cross-sectional image, the fiber base material having a thickness of 40 $\mu$m or more, the first resin layer, and the second resin layer are specified, and the minimum thickness of the first resin layer and the minimum thickness of the second resin layer in the field of view are measured. The measurement of the minimum thickness is performed in arbitrary five fields of view in which the regions do not overlap each other, and a value obtained by averaging all the minimum thicknesses of the five fields of view in the first resin layer is defined as the thickness $d_1$ of the first resin layer, and a value obtained by averaging all the minimum thicknesses of the five fields of view in the second resin layer is defined as the thickness $d_2$ of the second resin layer.

(Thickness $d_1$ of First Resin Layer and Thickness $d_2$ of Second Resin Layer)

The thickness $d_1$ of the first resin layer and the thickness $d_2$ of the second resin layer are not particularly limited, but are each preferably 2 to 20 $\mu$m, more preferably 5 to 15 $\mu$m, further preferably 6 to 13 $\mu$m, and particularly preferably 7 to 10 $\mu$m, from the viewpoint of further improving the ease of production and the thickness accuracy and the uniformity of the amount of dimensional change of the metal-clad laminate.

Note that only one of the thickness $d_1$ of the first resin layer and the thickness $d_2$ of the second resin layer may be within the above range.

The method for measuring the thickness $d_1$ of the first resin layer and the thickness $d_2$ of the second plastic layer is as described above.

(Surface Waviness (Wa))

The surface waviness (Wa) of both surfaces of the prepreg (P) used in the present embodiment is 6 $\mu$m or less.

The "surface" of the prepreg (P) in the present embodiment refers to a surface to be superposed or a surface on the opposite side when the prepreg (P) is laminated to produce a metal-clad laminate.

The surface waviness (Wa) of both surfaces of the prepreg (P) used in the present embodiment is preferably 5.5 $\mu$m or less, more preferably 5 $\mu$m or less, and further preferably 4 $\mu$m or less from the viewpoint of further improving the thickness accuracy and the uniformity of the amount of dimensional change of the metal-clad laminate.

The surface waviness (Wa) of both surfaces of the prepreg (P) used in the present embodiment is preferably as small as possible, but may be 0.5 $\mu$m or more, or may be 0.8 $\mu$m or more from the viewpoint of ease of production.

The surface waviness (Wa) in the present embodiment is an arithmetic average height (Wa) that can be obtained from a waviness curve in accordance with ISO 4287 (1997). The surface waviness (Wa) can be measured by a method described in Examples.

(Impregnated Region and Unimpregnated Region)

The prepreg (P) used in the present embodiment preferably has an impregnated region and an unimpregnated region of the thermosetting resin composition in the fiber base material.

When the thermosetting resin composition is completely impregnated into the fiber base material, the waviness of the fiber base material tends to appear on the surface of the prepreg (P). In particular, when the thickness of the fiber base material is 40 $\mu$m or more, this tendency becomes remarkable. On the other hand, by providing the unimpregnated region in the fiber base material, the waviness of the fiber base material is less likely to appear on the surface of the prepreg (P), and the surface waviness (Wa) of the prepreg (P) tends to be easily adjusted to 6 $\mu$m or less. It should be noted that the fact that the prepreg has an impregnated region and an unimpregnated region of the thermosetting resin composition in the fiber base material only relates to the prepreg, that is, the prepreg in a B-stage state, and does not relate to a cured product of the prepreg.

The unimpregnated region of the prepreg (P) used in the present embodiment is preferably present intermittently, and more preferably present intermittently in the plane direction.

When the unimpregnated region is intermittently present, the impregnation of the thermosetting resin composition into the unimpregnated region tends to easily proceed at the time of heating and pressurization when laminating the prepreg (P) and the metal foil, the occurrence of fine voids due to the unimpregnated region and the like are suppressed, and the insulation reliability tends to be improved.

Fig. 2 shows a schematic cross-sectional view of a prepreg 20 which is an example of the prepreg (P) in which the unimpregnated region is intermittently present in the plane direction.

The prepreg 20 shown in Fig. 2 has a thermosetting resin composition 5 on the front and back surfaces and inside the fiber base material 1, and includes an unimpregnated region 6 inside the fiber base material 1.

The "plane direction" of the prepreg means a direction along the surface of the fiber base material indicated by X in Fig. 2.

The abundance ratio of the impregnated region in the prepreg (P) can be obtained as an area ratio of the impregnated region by observing the surface of the prepreg (P) using an optical microscope, obtaining a surface observation image at a magnification of, for example, 50 times, and specifying an impregnated region and an unimpregnated region in the surface observation image.

To be specific, in the observation under the above-described conditions, in a surface observation image photographed at an appropriate brightness, a face in which the unimpregnated region of the thermosetting resin composition is present in a lower portion of the observed face is a void section portion and is likely to reflect light, and thus is represented as a relatively bright region, and the other region, that is, an impregnated region is represented as a relatively dark region.

The surface observation image is binarized so that a relatively bright region representing the unimpregnated region has one value and a relatively dark region representing the impregnated region has the other value, and in the obtained binarized image, the area ratio of the impregnated region to the entire area can be calculated.

Here, when the surface observation image is photographed, it is preferable to adjust the exposure time at the time of photographing the surfaces in the range of 60 to 100 ms because photographing is performed with appropriate brightness so that the impregnated region and the unimpregnated region can be sufficiently reflected.

In the surface observation image of the prepreg (P), there are the "region where the fiber base material is not present in the resin layer", the "region where the fiber base material is sufficiently impregnated with the thermosetting resin composition", and the "region where the fiber base material is not sufficiently impregnated with the thermosetting resin composition" in descending order of color intensity. In the present embodiment, the "region where the fiber base material is not present in the resin layer" is also included in the impregnated region. When the surface observation image is too bright, not only a portion in which the fiber base material is insufficiently impregnated with the resin but also a portion in which the fiber base material is sufficiently impregnated with the resin are likely to be brightly represented, and furthermore, when the image is bright, the surface observation image after binarization tends to be bright as a whole. On the other hand, when the surface observation image is too dark, the surface observation image becomes dark as a whole, and the presence of the unimpregnated region tends to be less likely to be reflected. Therefore, it is preferable to perform photographing with appropriate brightness. As the observation conditions, the observation conditions described in Examples are adopted in detail from the viewpoint of photographing with appropriate brightness.

Fig. 3 shows an example in which a surface observation image photographed with appropriate brightness is processed by the above method. Fig. 3 is an image obtained by binarizing the surface observation image of the prepreg prepared in Example 1. In Fig. 3, it can be observed that the impregnated region (black) and the unimpregnated region (white) are alternately present in the plane direction. The exposure time when the surface observation image is photographed is 85 ms.

The abundance ratio of the impregnated region measured by the above method is not particularly limited, but is preferably 30 to 99%, more preferably 50 to 98%, and further preferably 60 to 97%.

When the abundance ratio of the impregnated region is equal to or more than the above lower limit value, the thickness accuracy and the uniformity of the amount of dimensional change of the metal-clad laminate tend to be more easily improved. On the other hand, when the abundance ratio of the impregnated region is equal to or less than the above upper limit value, there is a tendency that powder falling of the prepreg (P) is suppressed, and the handleability is more easily improved.

(Fiber Base Material)

The fiber base material contained in the prepreg (P) used in the present embodiment is not particularly limited as long as it is a fiber base material having a thickness of 40 $\mu$m or more.

The thickness of the fiber base material may be appropriately adjusted within a range of 40 $\mu$m or more depending on the desired thickness of the metal-clad laminate and the like, and is not particularly limited, but is preferably 40 to 120 $\mu$m, more preferably 45 to 110 $\mu$m, further preferably 50 to 105 $\mu$m, still further preferably 55 to 100 $\mu$m, still further preferably 60 $\mu$m or more and less than 100 $\mu$m, still further preferably 70 to 97 $\mu$m, and particularly preferably 80 to 95 $\mu$m, from the viewpoint of further improving the thickness accuracy and the uniformity of the amount of dimensional change of the metal-clad laminate, and from the viewpoint of the productivity and the handleability of the prepreg (P). When the thickness of the fiber base material is equal to or less than the above upper limit value, the impregnation property of the thermosetting resin composition into the fiber base material is improved, and the heat resistance and the insulation reliability of the cured product of the prepreg (P) tend to be more favorable.

In the production method of the present embodiment, when a plurality of prepregs are laminated, the thicknesses of the fiber base materials contained in the respective prepregs may be the same as or different from each other.

The thickness of the fiber base material can be determined as a value obtained by measuring any five points of the fiber base material using a micrometer and averaging the measured values.

Examples of the material of the fiber base material include natural fibers such as paper and cotton linter; inorganic fibers such as glass fiber and asbestos; organic fibers such as aramid, polyimide, polyvinyl alcohol, polyester, tetrafluoroethylene, and acryl; and mixtures thereof. Among these, from the viewpoint of flame retardancy, inorganic fibers are preferable, and glass fiber is more preferable.

Examples of the glass fiber include glass fibers using E-glass, C-glass, D-glass, or S-glass.

The material of the fiber base material may be one kind alone or may be a combination of two or more kinds.

Examples of the shape of the fiber base material include shapes such as a woven fabric, a nonwoven fabric, a roving, a chopped strand mat, and a surfacing mat. Among these, a woven fabric is preferable.

Among the above options, glass cloth is preferable as the fiber base material from the viewpoint of low thermal expansion property, flame retardancy, versatility, and the like.

The fiber base material may be a single-layered fiber base material or may be a multi-layered fiber base material. However, in the case of a multi-layered fiber base material, at least one layer includes a fiber base material having a thickness of 40 $\mu$m or more. The single-layered fiber base material means a fiber base material consisting only of entangled fibers, and in a case where there is a fiber base material without entanglement, it is classified as a multi-layered fiber base material. The material and the shape of the fiber base material of two or more layers may be the same as or different from each other.

The surface waviness (Wa) of the fiber base material is not particularly limited, but may be more than 6 $\mu$m and 40 $\mu$m or less, may be 6.5 to 35 $\mu$m, may be 7 to 30 $\mu$m, may be 10 to 25 $\mu$m, or may be 15 to 23 $\mu$m.

According to the production method of the present embodiment, even when the surface waviness (Wa) of the fiber base material is within the above range, a metal-clad laminate excellent in thickness accuracy and uniformity of the amount of dimensional change can be obtained by adjusting the surface waviness (Wa) of the prepreg (P) to a predetermined range.

(Thermosetting Resin Composition)

The thermosetting resin composition is contained in the first resin layer and the second resin layer in the prepreg (P) used in the present embodiment, and may be impregnated into at least a part of the fiber base material.

The thermosetting resin composition contained in the prepreg (P) used in the present embodiment contains at least a thermosetting resin.

The thermosetting resin composition preferably contains, for example, at least one selected from the group consisting of a curing agent, a curing accelerator, an inorganic filler, an organic filler, a coupling agent, a leveling agent, an antioxidant, a flame retardant, a flame retardant aid, a thixotropy-imparting agent, a thickener, a flexible material, a surfactant, and a photopolymerization initiator, as necessary, in addition to the thermosetting resin.

Hereinafter, each component that can be contained in the thermosetting resin composition will be described.

It should be noted that one type of each component may be used alone, or two or more types may be used in combination.

[Thermosetting Resin]

Examples of the thermosetting resin include an epoxy resin, a polyimide resin, a maleimide resin, a modified maleimide resin, a phenol resin, a polyphenylene ether resin, a bismaleimide-triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

Among these, from the viewpoint of moldability and electrical insulation property, an epoxy resin, a polyimide resin, a maleimide resin, a modified maleimide resin, a cyanate resin, a polyphenylene ether resin, and a bismaleimide triazine resin are preferable, and an epoxy resin, a maleimide resin, and a modified maleimide resin are more preferable.

The epoxy resin is preferably an epoxy resin having two or more epoxy groups in one molecule. Here, the epoxy resin is classified into a glycidyl ether type epoxy resin, a glycidyl amine type epoxy resin, a glycidyl ester type epoxy resin, and the like. Among them, a glycidyl ether type epoxy resin is preferable.

The epoxy resin is classified into various epoxy resins depending on the difference in the main skeleton. For example, the above-mentioned respective types of epoxy resins are further classified into a bisphenol type epoxy resin; an alicyclic epoxy resin; an aliphatic chain epoxy resin; a novolac type epoxy resin; a stilbene type epoxy resin; a naphthalene skeleton-containing type epoxy resin; a biphenyl type epoxy resin; a xylylene type epoxy resin; and a dihydroanthracene type epoxy resin. Among these, a phenol novolac type epoxy resin and a naphthalene skeleton-containing type epoxy resin are preferable.

The maleimide resin is preferably a maleimide resin having one or more N-substituted maleimide groups and more preferably a maleimide resin having two or more N-substituted maleimide groups.

In addition, the maleimide resin is preferably an aromatic maleimide resin having an N-substituted maleimide group directly bonded to an aromatic ring.

Examples of the maleimide resin include aromatic bismaleimide resins having two N-substituted maleimide groups directly bonded to an aromatic ring, such as bis(4-maleimidophenyl)methane, bis(4-maleimidophenyl)ether, bis(4-maleimidophenyl)sulfone, 3,3'-dimethyl-5,5'-diethyl-4,4'-diphenylmethane bismaleimide, 4-methyl-1,3-phenylene bismaleimide, m-phenylene bismaleimide, and 2,2-bis[4-(4-maleimide phenoxy)phenyl]propane; aromatic polymaleimide resins having three or more N-substituted maleimide groups directly bonded to an aromatic ring, such as polyphenyl methane maleimide and biphenyl aralkyl type maleimide; maleimide resins having an indane ring skeleton; and aliphatic maleimide resins such as 1,6-bismaleimide-(2,2,4-trimethyl) hexane and pyrophosphate binder type long chain alkyl bismaleimide.

Examples of the modified maleimide resin include aminomaleimide resins having a structural unit derived from a maleimide resin and a structural unit derived from a diamine compound.

The diamine compound is preferably a compound having two primary amino groups.

In addition, the diamine compound is preferably an aromatic diamine compound having two primary amino groups directly bonded to an aromatic ring.

Examples of the diamine compound include aromatic diamines having two primary amino groups directly bonded to an aromatic ring, such as m-phenylenediamine, p-phenylenediamine, 1,4-bis(4-aminophenoxy)benzene, 4,4'-diaminodiphenylmethane, 3,3'-dimethyl-4,4'-diaminodiphenylmethane, 3,3'-diethyl-4,4'-diaminodiphenylmethane, 2,2-bis[4-(4-aminophenoxy)phenyl]propane, 4,4'-diaminobenzophenone, 4,4'-diaminodiphenyl ether, 3,3'-diaminodiphenyl sulfone, 4,4'-diaminodiphenyl sulfone, bis[4-(4-aminophenoxy)phenyl]sulfone, benzidine, 4,4'-bis(4-aminophenoxy)biphenyl, 4,4'-diaminodiphenyl sulfide, and 4,4'-diamino-3,3'-biphenyl diol; and silicone compounds having two primary amino groups.

The aminomaleimide resin can be synthesized by subjecting a maleimide resin and a diamine compound to a Michael addition reaction by a known method.

In the aminomaleimide resin, the equivalent ratio of the total equivalent (Ta2) of the groups derived from the -NH$_2$ group of the diamine compound to the total equivalent (Ta1) of the groups derived from the N-substituted maleimide group of the maleimide resin (Ta2/Ta1) is not particularly limited, but is preferably 0.05 to 10, more preferably 1 to 8, and further preferably 3 to 7 from the viewpoint of dielectric characteristics, heat resistance, flame retardancy, and glass transition temperature. The group derived from -NH$_2$ group of the diamine compound includes -NH$_2$ itself. In addition, the group derived from N-substituted maleimide group of the maleimide resin includes N-substituted maleimide group itself.

The content of the thermosetting resin in the thermosetting resin composition is not particularly limited, but is preferably 10 to 70% by mass, more preferably 15 to 50% by mass, and further preferably 20 to 40% by mass with respect to the total solid content (100% by mass) of the thermosetting resin composition from the viewpoint of heat resistance, moldability, processability, and conductor adhesiveness.

[Curing Agent]

Examples of the curing agent include a phenol-based curing agent, a cyanate ester-based curing agent, an acid anhydride-based curing agent, an amine-based curing agent, and an active ester group-containing compound. Among these, when an epoxy resin is used as the thermosetting resin, a phenol-based curing agent is preferable as the curing agent.

Preferred examples of the phenol-based curing agent include a cresol novolac type phenol resin, a biphenyl aralkyl type phenol resin, a phenol novolac type phenol resin, a naphthylene ether type phenol resin, and a triazine skeleton-containing phenol resin.

In a case where the thermosetting resin composition contains a curing agent, the content thereof is not particularly limited, but is preferably 20 to 200 parts by mass, more preferably 25 to 150 parts by mass, and further preferably 30 to 100 parts by mass with respect to 100 parts by mass of the thermosetting resin from the viewpoint of obtaining good curability.

In a case where the thermosetting resin composition contains a curing agent, the equivalent ratio of the functional group of the thermosetting resin to the functional group of the curing agent [(functional group of thermosetting resin)/(functional group of curing agent)] is not particularly limited, but is preferably 0.8 to 1.2 when the functional group of the curing agent is a phenolic hydroxy group, 0.2 to 0.4 when the functional group of the curing agent is an amino group, and 0.3 to 0.6 when the functional group of the curing agent is an active ester group.

[Curing Accelerator]

Examples of the curing accelerator include imidazole-based curing accelerators such as an imidazole compound and a derivative of an imidazole compound; phosphorus-based compounds; tertiary amine compounds; and quaternary ammonium compounds. Among these, imidazole-based curing accelerators are preferable from the viewpoint of obtaining a sufficient curing acceleration effect.

Examples of the imidazole compound include imidazole compounds such as 2-methylimidazole, 2-ethylimidazole, 2-undecylimidazole, 2-phenylimidazole, 1,2-dimethylimidazole, and 2,4-diamino-6-[2'-methylimidazolyl-(1')]ethyl-s-triazine.

Examples of the derivative of the imidazole compound include a salt of an imidazole compound and trimellitic acid, such as 1-cyanoethyl-2-phenylimidazolium trimellitate; a salt of an imidazole compound and isocyanuric acid; and a salt of an imidazole compound and hydrobromic acid.

In a case where the thermosetting resin composition contains a curing accelerator, the content thereof is not particularly limited, but is preferably 0.01 to 20 parts by mass, more preferably 0.1 to 10 parts by mass, and further preferably 0.4 to 2 parts by mass, with respect to 100 parts by mass of the thermosetting resin, from the viewpoint of a curing acceleration effect and storage stability.

[Inorganic Filler]

Examples of the inorganic filler include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide. Among these, silica and alumina are preferable from the viewpoint of reducing the coefficient of thermal expansion and reducing the relative permittivity and the dielectric dissipation factor, and silica and aluminum hydroxide are preferable from the viewpoint of the heat resistance.

The inorganic filler may have been surface-treated with a surface treatment agent such as a silane coupling agent.

In a case where the thermosetting resin composition contains an inorganic filler, the content thereof on a mass basis is not particularly limited, but is preferably 10 to 80% by mass, more preferably 20 to 75% by mass, further preferably 40 to 70% by mass, and particularly preferably 45 to 65% by mass with respect to the total solid content (100% by mass) of the thermosetting resin composition.

When the content of the inorganic filler is equal to or more than the lower limit value, the low thermal expansion property and the heat resistance tend to be more favorable. On the other hand, when the content of the inorganic filler is equal to or less than the upper limit value, the moldability and the conductor adhesiveness tend to be more favorable.

(Thickness of Prepreg (P))

The thickness of the prepreg (P) used in the present embodiment is not particularly limited, and may be appropriately adjusted according to the thickness of the fiber base material to be used, the desired thickness of the metal-clad laminate, and the like, but is preferably 50 to 160 $\mu$m, more preferably 70 to 140 $\mu$m, further preferably 80 to 125 $\mu$m, and particularly preferably 90 to 100 $\mu$m from the viewpoint of, for example, the thickness accuracy and uniformity of the amount of dimensional change of the metal-clad laminate, and the productivity and handleability of the prepreg (P).

In the present embodiment, the thickness of the prepreg means the thickness of one sheet of prepreg.

In addition, in the present embodiment, the thickness of the prepreg can be obtained as a value obtained by measuring any five points of the prepreg using a digimatic indicator and averaging the measured values.

(Method for Producing Prepreg (P))

The method for producing the prepreg (P) used in the present embodiment may be, for example, a method of laminating a film-shaped thermosetting resin composition (hereinafter, also referred to as a "resin film") on both surfaces of a fiber base material having a thickness of 40 $\mu$m or more (hereinafter, also referred to as a "lamination method"), or a method of immersing a fiber base material having a thickness of 40 $\mu$m or more in a thermosetting resin composition diluted with an organic solvent (hereinafter, also referred to as a "resin varnish"), followed by drying (hereinafter, also referred to as an "immersion method"). Among these, the prepreg (P) used in the present embodiment is preferably produced by a method of laminating a film-shaped thermosetting resin composition on both surfaces of a fiber base material having a thickness of 40 $\mu$m or more from the viewpoint that the thickness difference ratio R is easily adjusted to -9.0% to +9.0% and the surface waviness (Wa) is easily adjusted to 6 $\mu$m or less.

[Lamination Method]

The resin film used in the lamination method can be produced by, for example, a method in which a resin varnish is applied to the surface of a support and then dried.

The resin varnish can be prepared, for example, by adding the thermosetting resin and, if necessary, other components to an organic solvent, followed by mixing and stirring using a known mixer.

Examples of the organic solvent used for the resin varnish include alcohol-based solvents such as methanol, ethanol, methyl cellosolve, butyl cellosolve, and propylene glycol monomethyl ether; ketone-based solvents such as acetone, methyl ethyl ketone, methyl isobutyl ketone, butanone, cyclohexanone, and 4-methyl-2-pentanone; ester-based solvents such as ethyl acetate, butyl acetate, propylene glycol monomethyl ether acetate, and $\gamma$-butyrolactone; ether-based solvents such as tetrahydrofuran; aromatic solvents such as toluene, xylene, and mesitylene; nitrogen atom-containing solvents such as N,N-dimethylformamide, N,N-dimethylacetamide, and N-methylpyrrolidone; and sulfur atom-containing solvents such as dimethyl sulfoxide.

The solid content concentration of the resin varnish is not particularly limited, but is preferably 20 to 85% by mass, more preferably 40 to 80% by mass, and further preferably 50 to 70% by mass.

Examples of the method for applying the resin varnish include a method using a known coating device such as a comma coater, a bar coater, a kiss coater, a roll coater, a gravure coater, or a die coater.

The drying temperature and the drying time after the application of the resin varnish may be determined depending on the type and the amount of the organic solvent used. For example, in the case of a resin varnish containing 30 to 70% by mass of an organic solvent, a resin film can be suitably formed by drying at 50 to 160°C for 1 to 8 minutes.

Examples of the support include an organic film such as polyethylene terephthalate (PET), biaxially oriented polypropylene (OPP), polyethylene, polyvinyl fluoride, and polyimide; and a metal foil of a metal such as copper and aluminum or an alloy. The support may be a release film having a surface subjected to a release treatment with a release agent.

The thickness of the resin film may be appropriately determined depending on the thickness of the fiber base material, the desired thickness of the prepreg (P), and the like, and is not particularly limited, but is preferably 10 to 100 $\mu$m, more preferably 15 to 70 $\mu$m, and further preferably 18 to 50 $\mu$m.

The thickness of the resin film is an average value of values obtained by measuring the total thickness at any five points of a support-attached resin film, peeling off the resin film at the measurement points with an adhesive tape, measuring the thickness of only the support, and subtracting the thickness of only the support from the total thickness. A digimatic indicator can be used to measure the thickness.

Next, a method of laminating resin films on both surfaces of a fiber base material will be described.

First, two support-attached resin films are prepared, and are arranged on both surfaces of the fiber base material so that the resin films are in contact with the fiber base material. Thereafter, the arranged support-attached resin films are laminated on the fiber base material to impregnate the fiber base material with the resin films.

When the prepreg (P) is produced by a lamination method, for example, the thickness difference ratio R can be adjusted to -9.0% to +9.0% by reducing the difference in thickness between the resin film laminated on one surface of the fiber base material and the resin film laminated on the other surface of the fiber base material. The absolute value of the difference in thickness between the resin film laminated on one surface of the fiber base material and the resin film laminated on the other surface of the fiber base material is not particularly limited, but is preferably 2.5 μm or less, more preferably 1.5 μm or less, and further preferably 0.5 μm or less.

The method of lamination is not particularly limited, and for example, roll lamination may be used, or press lamination using a hot plate may be used.

The heating temperature at the time of lamination is not particularly limited, but is preferably 50 to 180°C, more preferably 100 to 170°C, and further preferably 120 to 165°C from the viewpoint that the thickness difference ratio R and the surface waviness (Wa) of the prepreg (P) are easily adjusted to the above ranges.

The applied pressure at the time of lamination is not particularly limited, but is preferably 0.05 to 1.5 MPa, more preferably 0.1 to 1.3 MPa, and further preferably 0.3 to 1.2 MPa from the viewpoint that the thickness difference ratio R and the surface waviness (Wa) of the prepreg (P) are easily adjusted to the above ranges.

The lamination may be performed under reduced pressure, and the vacuum degree in this case is not particularly limited, but is preferably 200 kPa or less, more preferably 150 kPa or less, and further preferably 120 kPa or less from the viewpoint that the thickness difference ratio R and the surface waviness (Wa) of the prepreg (P) are easily adjusted to the above ranges.

In the lamination method, examples of a method of intermittently providing the unimpregnated region in the fiber base material include a method of adjusting heating and pressurizing conditions at the time of laminating the support-attached resin film and the fiber base material.

Here, when the same lamination conditions are applied to the case where the fiber base material is thin and the case where the fiber base material is thick, the resin film tends to be more difficult to impregnate into the fiber base material in the case where the fiber base material is thick. Therefore, even if the conditions for laminating a resin film on a conventional thin fiber base material are similar to the lamination conditions of the present embodiment, it is possible to intermittently provide the unimpregnated region of the thermosetting resin composition in the fiber base material in the present embodiment.

Specific examples of the method for adjusting the heating and pressurizing conditions include the following methods. First, a prepreg is prepared under predetermined heating and pressurizing conditions, and then the abundance ratio of the impregnated region of the thermosetting resin composition in the fiber base material is determined based on the above-described calculation method. As a result, in a case where the impregnated region is 100%, that is, in a case where there is no unimpregnated region, the heating temperature or the applied pressure is lowered, or both the heating temperature and the applied pressure are lowered, the prepreg is prepared again, and the abundance ratio of the impregnated region is obtained again. By further repeating this as necessary, it is possible to easily grasp the conditions for producing a prepreg having the unimpregnated region.

In addition, in a case where it is desired to adjust the abundance ratio of the unimpregnated region to be low, the prepreg may be produced again by increasing the heating temperature, or increasing the applied pressure, or increasing both the heating temperature and the applied pressure. By the above operation, the conditions under which the waviness of the fiber base material is less likely to appear on the surface of the prepreg are extracted, and the surface waviness (Wa) of the prepreg can be adjusted to 6 μm or less.

After the fiber base material is impregnated with the resin film, the prepreg (P) can be obtained by peeling the support from the obtained support-attached prepreg (P) after cooling as necessary.

[Immersion Method]

Examples of the resin varnish used in the immersion method include the same resin varnishes as those used in the preparation of the resin film in the lamination method.

The drying temperature and the drying time after immersing the fiber base material in the resin varnish are not particularly limited, and may be appropriately determined in consideration of the type of the organic solvent, and the like.

<Metal Foil>

Examples of the metal type of the metal foil used in the production method of the present embodiment include copper, gold, silver, nickel, platinum, molybdenum, ruthenium, aluminum, tungsten, iron, titanium, chromium, and an alloy containing one or more kinds of these metal elements. Examples of the alloy include a copper-based alloy, an aluminum-based alloy, and an iron-based alloy. Examples of the copper-based alloy include a copper-nickel alloy. Examples of the iron-based alloy include an iron-nickel alloy.

Among these, from the viewpoint of conductivity and availability, copper, nickel, aluminum, and an iron-nickel alloy are preferable, copper and aluminum are more preferable, and copper is further preferable. When a copper foil is used as the metal foil, the resulting metal-clad laminate may be referred to as a copper-clad laminate.

The thickness of the metal foil is not particularly limited, but is preferably 1 to 200 μm, more preferably 2 to 100 μm, and further preferably 3 to 50 μm.

The number of metal foils used in the production method of the present embodiment is not particularly limited, and may be one, but is preferably two.

In the metal-clad laminate obtained by the production method of the present embodiment, the metal foil is preferably disposed on at least one surface of the metal-clad laminate, and more preferably disposed on both surfaces of the metal-clad laminate.

<Method for Laminating Prepreg and Metal Foil>

The metal-clad laminate can be produced by arranging a metal foil on one surface or both surfaces of a prepreg, and then heating and pressurizing the prepreg.

At the time of heating and pressurizing, only one sheet of prepreg may be used, or two or more sheets of prepreg may be stacked and used, but at least one sheet of prepreg (P) is used. When two or more sheets of prepreg are used, it is preferred that all the prepregs are the prepreg (P).

When two or more sheets of prepreg are used, for example, the total number of sheets of the prepreg may be 2 to 20, may be 5 to 18, or may be 8 to 16.

As the method for producing a metal-clad laminate having metal foils on both surfaces, a production method described in the section of [Metal-Clad Laminate] described later is also preferable.

Further, in addition to the prepreg and the metal foil, a substrate subjected to inner layer circuit processing may be included and molded under heating and pressure.

For the heating and pressurization, for example, a multi-stage press, a multi-stage vacuum press, a continuous molding, or an autoclave molding machine can be used.

The heating temperature at the time of heating and pressurization is not particularly limited, but is preferably 100 to 300°C, more preferably 150 to 260°C, and further preferably 170 to 230°C.

The heating and pressurizing time at the time of heating and pressurization is not particularly limited, but is preferably 10 to 300 minutes, more preferably 30 to 200 minutes, and further preferably 60 to 150 minutes.

The applied pressure at the time of heating and pressurization is not particularly limited, but is preferably 1.0 to 6 MPa, more preferably 1.5 to 3 MPa, and further preferably 1.8 to 2.5 MPa.

For the heating and pressurization, a method of raising the temperature while applying pressure may be employed. In this case, it is preferable that the maximum temperature is in the above-described suitable heating temperature range, and the holding time at the maximum temperature is in the above-described suitable heating and pressurizing time range.

The temperature raising rate in the case of raising the temperature while applying pressure is not particularly limited, but is preferably 1 to 10°C/min, and more preferably 2 to 5°C/min.

In the case of raising the temperature while applying pressure, the timing of the pressure application is not particularly limited, but the temperature may be raised after starting the pressure application at room temperature.

The thickness of the metal-clad laminate produced by the production method of the present embodiment is not particularly limited, and may be 400 to 2,500 $\mu$m, may be 450 to 2,000 $\mu$m, may be 500 to 1,800 $\mu$m, or may be 550 to 1,600 $\mu$m.

The thickness of the metal-clad laminate can be measured by the method for measuring $T_{ave}$ in Examples.

As described above, according to the production method of the present embodiment, a metal-clad laminate having excellent thickness accuracy can be produced. Therefore, in the production method of the present embodiment, it is possible to omit a smoothing treatment performed on the cured product of the prepreg in order to improve the thickness accuracy of the metal-clad laminate. Examples of the smoothing treatment include a method of pressurizing the cured product of the prepreg with a roll, and a method of polishing the surface of the cured product of the prepreg.

When the metal-clad laminate produced by the production method of the present embodiment and the metal-clad laminate of the present embodiment described later contain a plurality of fiber base materials, from the viewpoint of productivity, the thickness of the fiber base material positioned on the outermost side on at least one surface side of the metal-clad laminate may be in a range of 0.6 to 1.3 times, may be in a range of 0.7 to 1.3 times, may be in a range of 0.8 to 1.2 times, or may be in a range of 0.9 to 1.1 times the thickness of the fiber base material adjacent to the fiber base material positioned on the outermost side. It is preferable that the thicknesses of the fiber base materials positioned on the outermost side on both surface sides of the metal-clad laminate are each in the above-described range with respect to the thickness of the adjacent fiber base material.

[Method for Producing Printed Wiring Board]

The method for producing a printed wiring board of the present embodiment is a method for producing a printed wiring board in which a metal-clad laminate is produced by the method for producing a metal-clad laminate of the present embodiment, and a wiring pattern is formed on the metal-clad laminate. The wiring pattern can be formed by a known method. If necessary, the metal foil may be appropriately subjected to etching, drilling, metal plating, or the like by a known method.

[Method for Producing Semiconductor Package]

The method for producing a semiconductor package of the present embodiment is a method for producing a semiconductor package in which a printed wiring board is produced by the method for producing a printed wiring board of the present embodiment, and a semiconductor element is mounted on the printed wiring board.

The method for mounting the semiconductor element is not particularly limited, and a conventionally known method can be applied. Specifically, a semiconductor chip may be bonded to the printed wiring board, for example, by aligning the electrode of the printed wiring board and the bump of the semiconductor chip, then temporarily fixing them, and applying a reflow method, a TCB (Thermal Compression Bonding) method, or the like.

Thereafter, the gap between the printed wiring board and the semiconductor chip may be sealed with a liquid sealing material. Further, a part or the whole of the surface of the semiconductor chip may be sealed with a semiconductor sealing material. As the liquid sealing material and the semiconductor sealing material, conventionally known materials can be used.

[Metal-Clad Laminate]

The metal-clad laminate of the present embodiment is a metal-clad laminate having a cured product of a thermosetting resin composition, one or more layers of a fiber base material, and a metal foil, in which the fiber base material has a thickness of 40 $\mu$m or more, and a value obtained according to the following method is 0.5% or less.

(method)

The in-plane of the metal-clad laminate is sectioned in a grid shape at intervals of 50 mm in the vertical direction and the horizontal direction, respectively, and 21 measurement unit areas 7 each having a square shape of 50 mm in length × 50 mm in width when seen from a plan view are set at positions shown in a plan view of a metal-clad laminate 30 of Fig. 4.

thicknesses are measured at positions of four thickness measurement points 8 shown in Fig. 4, which are points 10 mm apart from the vertical side and the horizontal side of the measurement unit area 7 toward the inside of the measurement unit area 7, respectively, and a difference between a maximum value and a minimum value of the thicknesses at the four points is defined as a thickness difference $V_1$ in the measurement unit area 7, and an average value of the thicknesses at the four points is defined as $T_1$;

$V_1$ and $T_1$ are obtained for each of the 21 measurement unit areas 7, and a value is calculated from an average value $V_{ave}$ of $V_1$ and an average value $T_{ave}$ of $T_1$ by the following equation:

$$V_{ave} \times 100/T_{ave}.$$

More specifically, it can be measured by the method described in Examples.

The reason why the semiconductor package using the metal-clad laminate of the present embodiment has a small variation in the amount of warpage of the semiconductor package is not clear, but is presumed as follows.

Since the metal-clad laminate of the present embodiment has a value obtained by the above-described method of 0.5% or less and is excellent in thickness accuracy, the amount of thermal expansion of the substrate included in the semiconductor package produced using the metal-clad laminate became uniform among products, which is presumed to be one reason.

The metal-clad laminate of the present embodiment is a metal-clad laminate having a metal foil on both surfaces thereof, and including:

a first resin cured product layer which is provided on a surface of the fiber base material, is in contact with the metal foil on one surface of the metal-clad laminate, and contains a cured product of a thermosetting resin composition; and
a second resin cured product layer which is provided on the surface of the fiber base material, is in contact with the metal foil on the other surface of the metal-clad laminate, and contains a cured product of a thermosetting resin composition;
in which, when a thickness of the first resin cured product layer is d'$_1$ and a thickness of the second resin cured product layer is d'$_2$, a thickness difference ratio R' represented by the following formula (1') is preferably -9.0% to +9.0%,

$$R' = (d'_1 - d'_2) \times 100/(d'_1 + d'_2) \qquad (1').$$

The thickness difference ratio R' represented by the above general formula (1') is preferably -8.0% to +8.0%, more preferably -7.0% to +7.0%, further preferably -6.0% to +6.0%, particularly preferably -5.0% to +5.0%, from the viewpoint of further improving the thickness accuracy and the uniformity of the amount of dimensional change of the metal-clad laminate.

More detailed measurement conditions of the thickness difference ratio R' can be the conditions described in Examples.

The cured product of the thermosetting resin composition contained in the first resin cured product layer and the cured product of the thermosetting resin composition contained in the second resin cured product layer may be the same as or different from each other, but are preferably the same as each other.

In addition, in a case where the cured product of the thermosetting resin composition contained in the first resin cured product layer and the cured product of thermosetting resin composition contained in the second resin cured product layer are the same as each other, these cured products of the thermosetting resin compositions and the cured product of the thermosetting resin composition contained in the fiber base material may be the same as or different from each other, but are preferably the same as each other.

It is preferable that the first resin cured product layer and the second resin cured product layer do not contain a fiber base material.

The metal-clad laminate of the present embodiment is preferably produced by the production method described in the section of [Method for Producing Metal-Clad Laminate] above. That is, the metal-clad laminate of the present embodiment is preferably produced using the prepreg (P). Therefore, suitable aspects of the cured product of the thermosetting resin composition and the fiber base material of the metal-clad laminate of the present embodiment are the same as suitable aspects of the cured product of the thermosetting resin composition contained in the prepreg (P) and the fiber base material contained in the prepreg (P). Suitable aspects of the lamination configuration of each member, the production conditions, and the like when a metal-clad laminate is produced using the prepreg (P) are also as described in the section of [Method for Producing Metal-Clad Laminate] above.

In the case of producing a metal-clad laminate having metal foils on both surfaces, from the viewpoint of the thickness accuracy of the metal-clad laminate, when the metal foil and the prepreg are heated and pressurized, both the prepreg in contact with the metal foil on one surface and the prepreg in contact with the metal foil on the other surface are preferably the prepreg (P). As a result, the first resin cured product layer and the second resin cured product layer of the metal-clad laminate become layers formed of a cured product of the first resin layer or the second resin layer of the prepreg (P). As an aspect in which both the prepreg in contact with the metal foil on one surface and the prepreg in contact with the metal foil on the other surface are the prepreg (P), for example, an aspect in which the metal foils are laminated on both surfaces of one sheet of prepreg (P) may be employed. When a plurality of prepregs including two or more sheets of prepreg (P) are used, the plurality of prepregs may be stacked such that one sheet of prepreg (P) is exposed on one surface and another sheet of prepreg (P) is exposed on the other surface, and one metal foil may be laminated on the prepreg (P) exposed on the one surface and the other metal foil may be laminated on the prepreg (P) exposed on the other surface.

The thickness of the metal-clad laminate of the present embodiment may be 400 to 2,500 $\mu$m, may be 450 to 2,000 $\mu$m, may be 500 to 1,800 $\mu$m, or may be 550 to 1,600 $\mu$m.

The method for measuring the thickness of the metal-clad laminate is as described above.

[Printed Wiring Board]

The printed wiring board of the present embodiment is a printed wiring board having the metal-clad laminate of the present embodiment. The printed wiring board of the present embodiment can be produced by using the metal-clad laminate of the present embodiment as the metal-clad laminate in the method described in the above [Method for Producing Printed Wiring Board].

[Semiconductor Package]

The semiconductor package of the present embodiment is a semiconductor package having the printed wiring board of the present embodiment and a semiconductor element. The semiconductor package of the present embodiment can be produced by using the printed wiring board of the present embodiment as the printed wiring board in the method described in the above [Method for Producing Semiconductor Package].

Examples

Next, the present embodiment will be described in more detail with reference to the following Examples, but these Examples do not limit the present embodiment.

[Method for Measuring Thickness $d_1$ of First Resin Layer, Thickness $d_2$ of Second Resin Layer, and Thickness Difference Ratio R of Prepreg]

(1) Preparation of test specimen

The prepreg prepared in each of Examples and Comparative Examples was heat-treated at 170°C for 1 hour and subsequently at 200°C for 1 hour under an air atmosphere. The prepreg after the heat treatment was cast with an epoxy resin and polished using a polishing machine (manufactured by Refine Tec Ltd., trade name "Refine Polisher") to cut out a cross section, which was used as a test specimen.

(2) Measurement of thickness $d_1$ of first resin layer and thickness $d_2$ of second resin layer

The cross-section of the test specimen obtained in the above (1) was observed at an arbitrary magnification of 20 to 200 times using a metallurgical microscope to obtain a cross-sectional image. In the obtained cross-sectional image, the fiber base material having a thickness of 40 $\mu$m or more, the first resin layer, and the second resin layer were specified, and the minimum thickness of the first resin layer and the minimum thickness of the second resin layer in the field of view were measured. The measurement of the minimum thickness was performed in arbitrary five fields of view in which the regions did not overlap each other, and a value obtained by averaging all the minimum thicknesses of the five fields of view in the first resin layer was defined as the thickness $d_1$ of the first resin layer, and a value obtained by averaging all the minimum thicknesses of the five fields of view in the second resin layer was defined as the thickness $d_2$ of the second resin layer.
From the thickness $d_1$ of the first resin layer and the thickness $d_2$ of the second resin layer obtained above, the thickness difference ratio R was calculated based on the following formula (1).

$$R = (d_1 - d_2) \times 100/(d_1 + d_2) \qquad (1)$$

[Method for Measuring Thickness $d'_1$ of First Resin Cured Product Layer, Thickness $d'_2$ of Second Resin Cured Product Layer, and Thickness Difference Ratio R' of Metal-Clad Laminate]

(1) Preparation of test specimen

The metal-clad laminate prepared in each of Examples and Comparative Examples was polished using a polishing machine (manufactured by Refine Tec Ltd., trade name "Refine Polisher") to cut out a cross section, which was used as a test specimen.

(2) Measurement of thickness $d'_1$ of first resin cured product layer and thickness $d'_2$ of second resin cured product layer

The cross-section of the test specimen obtained in the above (1) was observed at an arbitrary magnification of 20 to 200 times using a metallurgical microscope to obtain a cross-sectional image.
In the obtained cross-sectional image, the first resin cured product layer provided on a surface of the fiber base material and in contact with the metal foil (copper foil) on one surface of the metal-clad laminate and the second resin cured product layer provided on a surface of the fiber base material and in contact with the metal foil (copper foil) on the other surface of the metal-clad laminate were specified, and the minimum thickness of the first resin cured product layer and the minimum thickness of the second resin cured product layer were each measured. The measurement of the minimum thickness was performed in arbitrary five fields of view in which the regions did not overlap each other, and a value obtained by averaging all the minimum thicknesses of the five fields of view in the first resin cured product layer was defined as the thickness $d'_1$ of the first resin cured product layer, and a value obtained by averaging all the minimum thicknesses of the five fields of view in the second resin cured product layer was defined as the thickness $d'_2$ of the second resin cured product layer.
From the thickness $d'_1$ of the first resin cured product layer and the thickness $d'_2$ of the second resin cured product layer obtained above, the thickness difference ratio R' was calculated based on the following formula (1').

$$R' = (d'_1 - d'_2) \times 100/(d'_1 + d'_2) \qquad (1')$$

[Method for Measuring Surface Waviness (Wa)]

Using a shape analysis laser microscope (manufactured by KEYENCE CORPORATION, trade name "VK-X100"), the shape of the prepreg produced in each of Examples and Comparative Examples was automatically measured by an observation application to obtain a waviness curve in accordance with ISO 4287 (1997). The obtained waviness curve was subjected to surface roughness analysis using an analysis application to calculate the surface waviness (Wa).

Here, the waviness curve is a curve obtained by applying a phase compensation type high-pass filter $\lambda c$ ($\lambda c = 80$ $\mu$m) to a cross-sectional curve and removing wavelengths less than 80 $\mu$m from the cross-sectional curve. The analysis range was set to 1,000 $\mu$m $\times$ 1,000 $\mu$m.

The surface waviness (Wa) was measured on both surfaces of the prepreg, and a larger value is shown in Table 1.

[Method for Measuring Abundance Ratio of Impregnated Region]

The abundance ratio of the impregnated region was measured by the following method.

(1) Acquisition of surface observation image

Surface observation images were obtained by observing the surfaces of the prepregs under the following conditions using an optical microscope (manufactured by Olympus Corporation, trade name "MX61L-F").

<Observation Conditions>

- Magnification: 50 times
- Observation mode: dark field
- Sensibility: ISO400
- Exposure time at the time of front surface photographing: 60 to 100 ms
- Brightness of observation environment: Two 35 W fluorescent lamps are installed 2 m above the observation stage.

The exposure time was adjusted between 60 ms and 100 ms so as to obtain an appropriate brightness capable of sufficiently reflecting the impregnated region and the unimpregnated region.

(2) Image processing

The surface observation image obtained above was binarized by image editing software so that the impregnated region was black and the unimpregnated region was white, and stored in a Microsoft Windows Bitmap Image (BMP) format. Next, the pixel value data for each pixel of the surface observation image after binarization stored in the BMP format was stored in a comma-separated values (CSV) format using image conversion software.

As the image editing software, "Microsoft Paint" (manufactured by Microsoft Corporation) was used. As the image conversion software, "bmp2csv" which is free software was used.

(3) Calculation of abundance ratio of impregnated region

The pixel value data stored in the CSV format was pasted to Microsoft Excel (manufactured by Microsoft Corporation), and the number of black portions (pixel value = 0) corresponding to the impregnated region and the number of white portions (pixel value = 1) corresponding to the unimpregnated region were counted. From these numbers, the ratio of the black portions to the total of the black portions and the white portions was determined, and this was defined as the abundance ratio of the impregnated region.

In the prepreg obtained in each of Comparative Examples 3 to 5, a region corresponding to the unimpregnated region could not be specified, and thus the prepreg was evaluated as "Not measurable".

[Measurement of Thickness of Metal-Clad Laminate]

Fig. 4 shows a plan view for illustrating a method for measuring the thickness of the metal-clad laminate.

As shown in Fig. 4, a region of 500 mm × 500 mm in the plane of the metal-clad laminate 30 was sectioned in a grid shape at intervals of 50 mm in the vertical direction and the horizontal direction, respectively, and 21 measurement unit areas 7 (hatched portions in Fig. 4) each having a square shape of 50 mm in length × 50 mm in width when seen from a plan view were set.

Next, as shown in the enlarged view of Fig. 4, thicknesses were measured at four points (points 8 in Fig. 4) separated by 10 mm from the vertical side and the horizontal side of the measurement unit area 7 to the inside of the measurement unit area 7, respectively, and a difference between a maximum value and a minimum value of the thicknesses at the four points was defined as a thickness difference $V_1$ in the measurement unit area 7, and an average value of the thicknesses at the four points was defined as $T_1$.

By the same method, the $V_1$ and the $T_1$ were obtained for each of the 21 measurement unit areas 7. The average value $V_{ave}$ of the obtained $V_1$ and the average value $T_{ave}$ of the obtained $T_1$ were calculated, and a value was determined by the following formula.

$$V_{ave} \times 100/T_{ave}$$

The value (unit: %) obtained from the above formula was used as an index of the thickness accuracy.

[Measurement of Variation in Amount of Dimensional Change of Metal-Clad Laminate]

As shown in Fig. 5, four metal-clad laminates each having a size of 340 mm × 250 mm were cut out from the metal-clad laminate produced in each example and used as substrates for evaluation. For the four substrates for evaluation, a total of four reference holes were provided at a portion of 1 cm in the vertical direction and 1 cm in the horizontal direction from the four corners, and the distances between adjacent holes were measured using a CNC image measuring machine (manufactured by Mitutoyo Corporation, trade name: QV-H606T1L-D), and the values were defined as "reference dimension".

Each substrate for evaluation thus obtained was immersed in a copper etching solution (type of chemical solution: ammonium persulfate, temperature: 40°C, treatment time: 5 minutes) to remove the copper foil of the substrate for evaluation.

Subsequently, the substrate for evaluation from which the copper foil was removed by etching was heated at 180°C for 1 hour in the air, then allowed to cool to 25°C, and heated again at 180°C for 1 hour in the air. Thereafter, the distances between adjacent holes were measured by the same method as described above, and the values were defined as "dimensions after heating".

From the respective dimensions obtained above, the rate of dimensional change after heating was calculated for the four substrates for evaluation based on the following formula.

Rate of dimensional change (%) = (dimension after heating - reference dimension) × 100/reference dimension

The rates of dimensional change of the four substrates for evaluation (two data in the vertical direction and two data in the horizontal direction per substrate) were measured, the standard deviation was calculated, and the standard deviation was defined as the value (unit: %) of the variation in the amount of dimensional change of the metal-clad laminate.

[Method for Evaluating Heat Resistance of Metal-Clad Laminate]

An evaluation substrate was prepared by cutting the metal-clad laminate obtained in each example to the size of 25 mm square, and the evaluation substrate was floated in a solder bath at a temperature of 288°C for 90 minutes to confirm the presence or absence of the occurrence of swelling. In the evaluation results, a case where swelling was not confirmed at the time of floating for 90 minutes was evaluated as "A", and a case where swelling was confirmed was evaluated as "B".

[Method for Measuring Variation in Amount of Warpage of Semiconductor Package]

Using the metal-clad laminate obtained in each example as a core layer, a build-up material (manufactured by Ajinomoto Co., Inc., trade name "GX92", thickness: 30 μm) (hereinafter, also referred to as "BU"), copper foil (manufactured by Mitsui Mining & Smelting Co., Ltd., trade name "3EC-M3-VLP", thickness: 12 μm), and a solder resist (manufactured by Resonac Corporation, trade name "SR-7300") (hereinafter, also referred to as "SR") were used to prepare a substrate having the following layer configuration (a rectangle having an outer shape of 60 mm × 60 mm in plan view).

(Layer Configuration of Substrate)

SR/copper foil (residual copper ratio 65%)/BU/BU/copper foil (residual copper ratio 100%)/BU/BU/copper foil (residual copper ratio 100%)/BU/BU/core layer/BU/BU/copper foil (residual copper ratio 100%)/BU/BU/copper foil (residual copper ratio 100%)/BU/BU/copper foil (residual copper ratio 65%)/SR

In the above substrate, the thickness of the SR is 20 $\mu$m, and the radius of a solder resist opening is 100 $\mu$m. Further, a pad diameter is 150 $\mu$m, and a pad pitch is 200 $\mu$m.

The respective layers were laminated by the following procedures (1) to (5).

(1) Two sheets of build-up materials were laminated on each of both surfaces of the metal-clad laminate obtained in each example, a copper foil was superimposed on each of the exposed surfaces of the build-up materials on both surfaces, and then heat curing was performed under the conditions of 180°C, 0.5 MPa, and 90 minutes.

(2) Two sheets of build-up materials were further laminated on each of both surfaces of the obtained laminate, a copper foil was superimposed on each of the exposed surfaces of the build-up materials on both surfaces, and then heat curing was performed under the same conditions as described above.

(3) The same operation as in (2) above was carried out, and two sheets of build-up materials and copper foils were further laminated on both sides.

(4) The copper foils on both sides of the laminate obtained in (3) above were etched so as to obtain a predetermined pattern.

(5) A solder resist layer provided with a predetermined opening was formed on both sides of the laminate subjected to (4) above using the solder resist.

Next, a semiconductor chip made of silicon was mounted at the center of one surface of the substrate obtained above. The semiconductor chip was mounted by bonding a bump provided on a circuit surface side of the semiconductor chip and a pad of the substrate by a TCB (Thermal Compression Bonding) method. The configuration of the semiconductor chip is as follows.

(Configuration of Semiconductor Chip)

- Chip size: a rectangle of 25 mm $\times$ 25 mm in plan view, thickness 0.725 mm
- Bump pitch: 200 $\mu$m
- Bump metal: Sn-Ag solder alloy is mounted on Cu pillar
- Bump height: Cu pillar; 45 $\mu$m, Sn-Ag solder alloy; 15 $\mu$m
- Bump size: $\phi$90 $\mu$m

After that, the gap between the semiconductor chip and the substrate was sealed with a liquid sealing material (manufactured by Resonac Corporation, trade name "CEL-C-3730 series") to obtain a semiconductor package.

Four semiconductor packages were produced from the metal-clad laminate obtained in each example by the above-described method, and the maximum amount of warpage at 25°C and the maximum amount of warpage at 260°C of each of the obtained four semiconductor packages were measured using a warpage measuring apparatus (manufactured by Akrometrix, trade name "TherMoire"). The temperature raising rate was 20°C per minute.

Next, the standard deviation (unit: $\mu$m) of the maximum amount of warpage at 25°C was calculated from the maximum amount of warpage at 25°C of each of the four semiconductor packages, and this was taken as the value of the variation in the amount of warpage of the semiconductor package at 25°C. In addition, the standard deviation (unit: $\mu$m) of the maximum amount of warpage at 260°C was calculated from the maximum amount of warpage at 260°C of each of the four semiconductor packages, and this was taken as the value of the variation in the amount of warpage of the semiconductor package at 260°C. The standard deviations shown in Table 1 are values rounded off to the first decimal place.

[Synthesis of Modified Maleimide Resin]

Synthesis Example 1

595.8 g of bis(4-maleimidophenyl)methane, 54.2 g of 4,4'-diaminodiphenylmethane, and 350.0 g of propylene glycol monomethyl ether were charged into a reaction vessel having a volume of 2 L which was capable of heating and cooling and was equipped with a thermometer, a stirring device, and a moisture quantitative determination instrument equipped with a reflux cooling pipe, and then reacted for 5 hours under reflux, thereby obtaining a solution of a modified maleimide resin.

[Production of Resin Varnish]

Production Example 1

(Resin Varnish A)

60 parts by mass of a phenol novolac type epoxy resin "EPICLON (registered trademark) N-770" (manufactured by DIC Corporation, epoxy equivalent: 188 g/eq), 40 parts by mass of a biphenyl aralkyl type phenol resin (manufactured by Meiwa Plastic Industries, Ltd., trade name "MEH-7700"), 17.5 parts by mass of aluminum hydroxide, 86 parts by mass of fused silica, 0.5 parts by mass of 2-methylimidazole, and methyl isobutyl ketone and cyclohexane as diluting solvents were added and mixed to prepare a resin varnish A having a solid content concentration of 65% by mass.

Production Example 2

(Resin Varnish B)

107 parts by mass of the solution of the modified maleimide resin obtained in Synthesis Example 1, 30 parts by mass of a tetrafunctional naphthalene type epoxy resin "EXA-4710" (manufactured by DIC Corporation), 17.5 parts by mass of aluminum hydroxide, 130 parts by mass of fused silica, 0.5 parts by mass of 2,4-diamino-6-[2'-undecylimidazolyl-(1)']-ethyl-S-triazine, and methyl isobutyl ketone and cyclohexanone as diluting solvents were added and mixed to prepare a resin varnish B having a solid content concentration of 65% by mass.

Example 1

(1) Production of Resin Film

The resin varnish shown in Table 1 was applied onto a PET film using a comma coater such that the thickness of the resin film after drying was 30 μm. Thereafter, the film was heated and dried at 130°C for 2 minutes to produce a resin film with a PET film.

(2) Production of Prepreg

Next, the resin film with the PET film was arranged on both surfaces of the fiber base material shown in Table 1 such that the resin film surface of the resin film with the PET film was in contact with the glass cloth, and the resin film with the PET film and the glass cloth were laminated using a vacuum laminator. The conditions of the vacuum lamination were a hot plate temperature of 130°C, a pressure bonding pressure of 0.5 MPa, a heating and pressurizing time of 30 seconds, a vacuum degree of 100 kPa or less, and a vacuum time of 30 seconds.

(3) Production of Metal-Clad Laminate

The obtained prepregs were stacked, the number which being shown in Table 1, and copper foils (manufactured by Furukawa Electric Co., Ltd., trade name "GTS-12", thickness: 12 μm) were arranged on the upper and lower sides thereof. Then, pressing was performed under the following conditions, thereby producing a metal-clad laminate having a square shape having a length of 1,000 mm × a width of 1,000 mm when seen from a plan view.

<Pressing Conditions>

Heating conditions: the temperature was raised from 25°C to 185°C at a temperature raising rate of 3°C/min, held at 185°C for 90 minutes, and then cooled for 30 minutes.

Pressure conditions: 4 MPa from the start of temperature rise to the end of cooling.

Example 2

A resin film, a prepreg, and a metal-clad laminate were produced by performing the same operation as in Example 1, except that the number of stacked prepreg sheets in "(3) Production of Metal-Clad Laminate" of Example 1 was changed to 8.

Example 3

A resin film, a prepreg, and a metal-clad laminate were produced by performing the same operation as in Example 1, except that the conditions of the vacuum lamination in "(2) Production of Prepreg" of Example 1 were changed to a hot plate temperature of 150°C, a pressure bonding pressure of 0.7 MPa, a heating and pressurizing time of 60 seconds, a vacuum degree of 100 kPa or less, and a vacuum time of 60 seconds.

Example 4

(1) Production of Resin Film

Resin films were produced by performing the same operation as in Example 1, except that the thickness of the resin film after drying was changed to 30.5 $\mu$m and 29.5 $\mu$m.

(2) Production of Prepreg

A prepreg was produced by performing the same operation as in Example 1, except that the resin film having a thickness of 30.5 $\mu$m was arranged so as to be in contact with one surface of the fiber base material and the resin film having a thickness of 29.5 $\mu$m was arranged so as to be in contact with the other surface of the fiber base material and lamination was performed, and the conditions of the vacuum lamination were changed to a hot plate temperature of 150°C, a pressure bonding pressure of 0.7 MPa, a heating and pressurizing time of 60 seconds, a vacuum degree of 100 kPa or less, and a vacuum time of 60 seconds.

(3) Production of Metal-Clad Laminate

A metal-clad laminate was produced by performing the same operation as in Example 1, except that the prepreg obtained above was used.

Example 5

(1) Production of Resin Film

Resin films were produced by performing the same operation as in Example 1, except that the thickness of the resin film after drying was changed to 20.5 $\mu$m and 19.5 $\mu$m.

(2) Production of Prepreg

A prepreg was produced by performing the same operation as in Example 1, except that the type of the fiber base material was changed to that shown in Table 1, the resin film having a thickness of 20.5 $\mu$m was arranged so as to be in contact with one surface of the fiber base material and the resin film having a thickness of 19.5 $\mu$m was arranged so as to be in contact with the other surface of the fiber base material and lamination was performed, and the conditions of the vacuum lamination were changed to a hot plate temperature of 150°C, a pressure bonding pressure of 0.7 MPa, a heating and pressurizing time of 60 seconds, a vacuum degree of 100 kPa or less, and a vacuum time of 60 seconds.

(3) Production of Metal-Clad Laminate

A metal-clad laminate was produced by performing the same operation as in Example 1, except that the prepreg obtained above was used.

Example 6

(1) Production of Resin Film

Resin films were produced by performing the same operation as in Example 1, except that the thickness of the resin film after drying was changed to 31 $\mu$m and 29 $\mu$m.

(2) Production of Prepreg

A prepreg was produced by performing the same operation as in Example 1, except that the resin film having a thickness of 31 $\mu$m was arranged so as to be in contact with one surface of the fiber base material and the resin film having a thickness of 29 $\mu$m was arranged so as to be in contact with the other surface of the fiber base material and lamination was performed, and the conditions of the vacuum lamination were changed to a hot plate temperature of 160°C, a pressure bonding pressure of 1.0 MPa, a heating and pressurizing time of 60 seconds, a vacuum degree of 100 kPa or less, and a vacuum time of 60 seconds.

(3) Production of Metal-Clad Laminate

A metal-clad laminate was produced by performing the same operation as in Example 1, except that the prepreg obtained above was used.

Example 7

A resin film, a prepreg, and a metal-clad laminate were produced by performing the same operation as in Example 6, except that the type of resin varnish was changed to that shown in Table 1 in "(1) Production of Resin Film" of Example 6.

Comparative Example 1

(1) Production of Resin Film

Resin films were produced by performing the same operation as in Example 1, except that the thickness of the resin film after drying was changed to 32 $\mu$m and 28 $\mu$m.

(2) Production of Prepreg

A prepreg was produced by performing the same operation as in Example 1, except that the resin film having a thickness of 32 $\mu$m was arranged so as to be in contact with one surface of the fiber base material and the resin film having a thickness of 28 $\mu$m was arranged so as to be in contact with the other surface of the fiber base material, and the conditions of the vacuum lamination were changed to a hot plate temperature of 100°C, a pressure bonding pressure of 0.2 MPa, a heating and pressurizing time of 30 seconds, a vacuum degree of 100 kPa or less, and a vacuum time of 30 seconds.

(3) Production of Metal-Clad Laminate

A metal-clad laminate was produced by performing the same operation as in Example 1, except that the prepreg obtained above was used.

Comparative Example 2

(1) Production of Resin Film

Resin films were produced by performing the same operation as in Example 1, except that the thickness of the resin film after drying was changed to 32 $\mu$m and 29 $\mu$m.

(2) Production of Prepreg

A prepreg was produced by performing the same operation as in Example 1, except that the resin film having a thickness of 32 $\mu$m was arranged so as to be in contact with one surface of the fiber base material and the resin film having a

thickness of 29 μm was arranged so as to be in contact with the other surface of the fiber base material and lamination was performed.

(3) Production of Metal-Clad Laminate

A metal-clad laminate was produced by performing the same operation as in Example 1, except that the prepreg obtained above was used.

Comparative Example 3

The fiber base material shown in Table 1 was immersed in the resin varnish shown in Table 1 and dried at 140°C for 3.5 minutes to obtain a prepreg. Thereafter, the same operation as in Example 1 was performed to produce a metal-clad laminate.

Comparative Example 4

The fiber base material shown in Table 1 was immersed in the resin varnish shown in Table 1 and dried at 140°C for 3.5 minutes to obtain a prepreg. Thereafter, the same operation as in Example 1 was performed to produce a metal-clad laminate.

Comparative Example 5

The fiber base material shown in Table 1 was immersed in the resin varnish shown in Table 1 and dried at 140°C for 3.5 minutes to obtain a prepreg. Thereafter, the same operation as in Example 1 was performed to produce a metal-clad laminate.

Table 1

| | | Examples | | | | | | |
|---|---|---|---|---|---|---|---|---|
| | | 1 | 2 | 3 | 4 | 5 | 6 | 7 |
| Prepreg | Type of resin varnish used in the production of prepreg | A | A | A | A | A | A | B |
| | Type of fiber base material used in the production of prepreg | 2116 | 2116 | 2116 | 2116 | 1078 | 2116 | 2116 |
| | Thickness $d_1$ (μm) of the first resin layer | 9.2 | 9.2 | 9.2 | 9.3 | 7.5 | 9.8 | 9.8 |
| | Thickness $d_2$ (μm) of the second resin layer | 9.0 | 9.0 | 9.0 | 8.8 | 6.9 | 8.3 | 8.3 |
| | Thickness difference ratio R (%) between thickness $d_1$ and thickness $d_2$ | 1.1 | 1.1 | 1.1 | 3.3 | 4.2 | 8.8 | 8.8 |
| | Surface waviness (Wa) (μm) | 1 | 1 | 3 | 3 | 3 | 5 | 5 |
| | Abundance ratio (%) of impregnated region | 62 | 62 | 95 | 95 | 95 | 97 | 97 |
| Metal-clad laminate | Number of stacked prepreg sheets in the production of metal-clad laminate | 12 | 8 | 12 | 12 | 12 | 12 | 12 |
| | Thickness $d'_1$ (μm) of the first resin cured product layer | 4.5 | 4.5 | 4.6 | 4.8 | 3.7 | 4.8 | 4.8 |
| | Thickness $d'_2$ (μm) of the second resin cured product layer | 4.4 | 4.4 | 4.5 | 4.5 | 3.4 | 4.0 | 4.1 |
| | Thickness difference ratio R' (%) between thickness $d'_1$ and thickness $d'_2$ | 1.1 | 1.1 | 1.1 | 3.2 | 4.2 | 9.1 | 7.6 |

(continued)

| | | Examples | | | | | | |
|---|---|---|---|---|---|---|---|---|
| | | 1 | 2 | 3 | 4 | 5 | 6 | 7 |
| Evaluation results | **Value** (%) **calculated** by $V_{ave} \times 100/T_{ave}$ | 0.2 | 0.2 | 0.2 | 0.3 | 0.3 | 0.4 | 0.4 |
| | Variation (%) in amount of dimensional change of metal-clad laminate - | 0.002 | 0.002 | 0.002 | 0.002 | 0.003 | 0.003 | 0.003 |
| | Heat resistance of metal-clad laminate | A | A | A | A | A | A | A |
| | Variation ($\mu$m) in amount of warpage of semiconductor package (25°C) | 5 | 4 | 5 | 6 | 7 | 9 | 9 |
| | Variation ($\mu$m) in amount of warpage of semiconductor package (260°C) | 4 | 3 | 4 | 4 | 5 | 6 | 6 |

Table 1 (continued)

| | | Comparative Example | | | | |
|---|---|---|---|---|---|---|
| | | 1 | 2 | 3 | 4 | 5 |
| Prepreg | Type of resin varnish used in the production of prepreg | A | A | A | B | A |
| | Type of fiber base material used in the production of prepreg | 2116 | 2116 | 2116 | 2116 | 2116 |
| | Thickness $d_1$ ($\mu$m) of the first resin layer | 10.0 | 10.0 | 10.0 | 9.5 | 9.7 |
| | Thickness $d_2$ ($\mu$m) of the second resin layer | 8.1 | 8.1 | 8.1 | 8.6 | 8.4 |
| | Thickness difference ratio R (%) between thickness $d_1$ and thickness $d_2$ | 10.5 | 10.5 | 10.5 | 5.0 | 7.2 |
| | Surface waviness (Wa) ($\mu$m) | 2 | 2 | 8 | 7 | 7 |
| | Abundance ratio (%) of impregnated region | 25 | 62 | *1 | *1 | *1 |
| Metal-clad laminate | Number of stacked prepreg sheets in the production of metal-clad laminate | 12 | 12 | 12 | 12 | 12 |
| | Thickness $d'_1$ ($\mu$m) of the first resin cured product layer | 5.1 | 5.0 | 5.2 | 4.8 | 4.9 |
| | Thickness $d'_2$ ($\mu$m) of the second resin cured product layer | 4.1 | 4.1 | 4.2 | 4.3 | 4.2 |
| | Thickness difference ratio R' (%) between thickness $d'_1$ and thickness $d'_2$ | 10.9 | 9.9 | 10.6 | 5.5 | 7.7 |

(continued)

|  | | Comparative Example | | | | |
|---|---|---|---|---|---|---|
|  | | 1 | 2 | 3 | 4 | 5 |
| Evaluation results | Value (%) calculated by $V_{ave} \times 100/T_{ave}$ | 0.2 | 0.2 | 0.9 | 0.8 | 0.8 |
|  | Variation (%) in amount of dimensional change of metal-clad laminate - | 0.006 | 0.006 | 0.009 | 0.009 | 0.008 |
|  | Heat resistance of metal-clad laminate | B | A | A | A | A |
|  | Variation ($\mu$m) in amount of warpage of semiconductor package (25°C) | 6 | 5 | 18 | 16 | 17 |
|  | Variation ($\mu$m) in amount of warpage of semiconductor package (260°C) | 5 | 4 | 14 | 12 | 13 |
| *1: Not measurable | | | | | | |

Details of the fiber base materials shown in Table 1 are as follows.

"2116": Glass cloth "IPC #2116" (manufactured by Nitto Boseki Co., Ltd., basis weight: 104 g/m², thickness: 91 $\mu$m, surface waviness (Wa): 21.9 $\mu$m)

"1078": Glass cloth "IPC #1078" (manufactured by Nitto Boseki Co., Ltd., basis weight: 47 g/m², thickness: 44 $\mu$m, surface waviness (Wa): 7.3 $\mu$m)

From Table 1, the metal-clad laminates produced in Examples 1 to 7 of the present embodiment were excellent in thickness accuracy and uniformity of the amount of dimensional change. In addition, the semiconductor packages produced using the metal-clad laminates produced in Examples 1 to 7 of the present embodiment had a small variation in the amount of warpage.

Reference Signs List

10, 20, 30: Metal-clad laminate
1: Fiber base material
2: First resin layer
3: Second resin layer
5: Thermosetting resin composition
6: Unimpregnated region
7: Measurement unit area
8: Thickness measurement point
X: Plane direction

**Claims**

1. A method for producing a metal-clad laminate, comprising: laminating a prepreg and a metal foil by heating and pressurizing,

wherein the prepreg contains a thermosetting resin composition and a fiber base material having a thickness of 40 $\mu$m or more,
the prepreg has a first resin layer which is provided on one surface of the fiber base material and contains the thermosetting resin composition; and a second resin layer which is provided on the other surface of the fiber base material and contains the thermosetting resin composition,
wherein when a thickness of the first resin layer is $d_1$ and a thickness of the second resin layer is $d_2$, a ratio R of a thickness difference represented by the following formula (1) is -9.0% to +9.0%,

$$R = (d_1 - d_2) \times 100/(d_1 + d_2) \qquad (1),$$

and

surface waviness (Wa) of each of both surfaces of the prepreg is 6 $\mu$m or less.

2. The method for producing a metal-clad laminate according to claim 1, wherein the prepreg has an impregnated region and an unimpregnated region of the thermosetting resin composition in the fiber base material.

3. The method for producing a metal-clad laminate according to claim 1 or 2, wherein the thickness $d_1$ of the first resin layer and the thickness $d_2$ of the second resin layer are each 2 to 20 $\mu$m.

4. The method for producing a metal-clad laminate according to claim 1 or 2, wherein the thickness of the fiber base material is 40 to 120 $\mu$m.

5. The method for producing a metal-clad laminate according to claim 1 or 2, wherein the fiber base material is a glass cloth.

6. A method for producing a printed wiring board, comprising: producing a metal-clad laminate by the method for producing a metal-clad laminate according to claim 1 or 2; and forming a wiring pattern on the metal-clad laminate.

7. A method for producing a semiconductor package, comprising: producing a printed wiring board by the method for producing a printed wiring board according to claim 6; and mounting a semiconductor element on the printed wiring board.

8. A metal-clad laminate comprising a cured product of a thermosetting resin composition, one or more layers of a fiber base material, and a metal foil, wherein the fiber base material has a thickness of 40 $\mu$m or more, and a value obtained according to the following method is 0.5% or less:
   (method)

   a region of 500 mm $\times$ 500 mm in the plane of the metal-clad laminate is sectioned in a grid shape at intervals of 50 mm in the vertical direction and the horizontal direction, respectively, and 21 measurement unit areas 7 each having a square shape of 50 mm in length $\times$ 50 mm in width when seen from a plan view are set at positions shown in a plan view of a metal-clad laminate 30 of Fig. 4;
   thicknesses are measured at positions of four thickness measurement points 8 shown in Fig. 4, which are points 10 mm apart from the vertical side and the horizontal side of the measurement unit area 7 toward the inside of the measurement unit area 7, respectively, and a difference between a maximum value and a minimum value of the thicknesses at the four points is defined as a thickness difference $V_1$ in the measurement unit area 7, and an average value of the thicknesses at the four points is defined as $T_1$;
   $V_1$ and $T_1$ are obtained for each of the 21 measurement unit areas 7, and a value is calculated from an average value $V_{ave}$ of $V_1$ and an average value $T_{ave}$ of $T_1$ by the following equation:

$$V_{ave} \times 100/T_{ave}.$$

9. The metal-clad laminate according to claim 8, wherein the metal-clad laminate has the metal foil on both surfaces thereof, and includes:

   a first resin cured product layer which is provided on a surface of the fiber base material, is in contact with the metal foil on one surface of the metal-clad laminate, and contains a cured product of a thermosetting resin composition; and
   a second resin cured product layer which is provided on a surface of the fiber base material, is in contact with the metal foil on the other surface of the metal-clad laminate, and contains a cured product of a thermosetting resin composition;
   wherein, when a thickness of the first resin cured product layer is $d'_1$ and a thickness of the second resin cured product layer is $d'_2$, a ratio R' of a thickness difference represented by the following formula (1') is -9.0% to +9.0%,

$$R' = (d'_1 - d'_2) \times 100/(d'_1 + d'_2) \qquad (1').$$

10. A printed wiring board comprising the metal-clad laminate according to claim 8 or 9.

11. A semiconductor package comprising the printed wiring board according to claim 10, and a semiconductor element.

[Fig. 1]

[Fig. 2]

[Fig. 3]

[Fig. 4]

[Fig. 5]

## INTERNATIONAL SEARCH REPORT

| International application No. |
| --- |
| **PCT/JP2023/043679** |

### A. CLASSIFICATION OF SUBJECT MATTER

**B32B 15/08**(2006.01)i; **B32B 38/08**(2006.01)i; **C08J 5/24**(2006.01)i; **H05K 1/03**(2006.01)i; **H05K 3/46**(2006.01)i
FI:   B32B15/08 105Z; B32B38/08; H05K1/03 610T; H05K3/46 G; H05K3/46 T; H05K3/46 S; C08J5/24 CFC

According to International Patent Classification (IPC) or to both national classification and IPC

### B. FIELDS SEARCHED

Minimum documentation searched (classification system followed by classification symbols)

B32B15/08; B32B38/08; C08J5/24; H05K1/03; H05K3/46

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2017/122820 A1 (HITACHI CHEMICAL COMPANY, LTD.) 20 July 2017 (2017-07-20) claims, paragraphs [0001]-[0019], [0040]-[0056], fig. 1 | 1, 3-11 |
| A | | 2 |
| L | WO 2017/122819 A1 (HITACHI CHEMICAL COMPANY, LTD.) 20 July 2017 (2017-07-20) paragraph [0063] | 1, 2-11 |
| P, X | WO 2022/254587 A1 (SHOWA DENKO MATERIALS CO., LTD.) 08 December 2022 (2022-12-08) claims, paragraphs [0001]-[0075], fig. 1-4 | 1-11 |
| A | WO 2020/144861 A1 (HITACHI CHEMICAL COMPANY, LTD.) 16 July 2020 (2020-07-16) entire text | 1-11 |
| A | JP 2019-199062 A (MITSUBISHI HEAVY INDUSTRIES, LTD.) 21 November 2019 (2019-11-21) entire text | 1-11 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **06 February 2024** | **20 February 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
|---|
| **PCT/JP2023/043679** |

**C.     DOCUMENTS CONSIDERED TO BE RELEVANT**

| Category* | Citation of document, with indication, where appropriate, of the relevant passages | Relevant to claim No. |
|---|---|---|
| A | JP 2013-180406 A (SUMITOMO BAKELITE CO., LTD.) 12 September 2013 (2013-09-12)<br>entire text | 1-11 |
| A | JP 2009-19151 A (PANASONIC CORPORATION) 29 January 2009 (2009-01-29)<br>entire text | 1-11 |

Form PCT/ISA/210 (second sheet) (July 2022)

| | INTERNATIONAL SEARCH REPORT | | International application No. | |
|---|---|---|---|---|
| | Information on patent family members | | **PCT/JP2023/043679** | |

| Patent document cited in search report | | | Publication date (day/month/year) | Patent family member(s) | | | Publication date (day/month/year) |
|---|---|---|---|---|---|---|---|
| WO | 2017/122820 | A1 | 20 July 2017 | US | 2019/0037691 | A1 | |
| | | | | claims, paragraphs [0001]- [0056], [0097]-[0135], fig. 1 | | | |
| | | | | EP | 3403801 | A1 | |
| | | | | CN | 108472831 | A | |
| | | | | KR | 10-2018-0103061 | A | |
| | | | | TW | 201736459 | A | |
| | | | | TW | 202138441 | A | |
| WO | 2017/122819 | A1 | 20 July 2017 | US | 2019/0021175 | A1 | |
| | | | | paragraph [0166] | | | |
| | | | | EP | 3403800 | A1 | |
| | | | | CN | 108463321 | A | |
| | | | | KR | 10-2018-0101380 | A | |
| | | | | TW | 201728447 | A | |
| WO | 2022/254587 | A1 | 08 December 2022 | TW | 202248318 | A | |
| WO | 2020/144861 | A1 | 16 July 2020 | CN | 113272131 | A | |
| | | | | KR | 10-2021-0113229 | A | |
| JP | 2019-199062 | A | 21 November 2019 | US | 2021/0008818 | A1 | |
| | | | | WO | 2019/220914 | A1 | |
| | | | | EP | 3647012 | A1 | |
| | | | | CN | 110997268 | A | |
| JP | 2013-180406 | A | 12 September 2013 | (Family: none) | | | |
| JP | 2009-19151 | A | 29 January 2009 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1272416 A